# EUROPÄISCHE PATENTSCHRIFT

(11) **EP 1 420 447 B1**
(45) Veröffentlichungstag und Bekanntmachung des Hinweises auf die Patenterteilung: **18.03.2009**
(21) Anmeldenummer: 03104114.8
(22) Anmeldetag: 07.11.2003
(51) Int. Cl.: H01L 23/522, H01L 23/532, H01L 21/768, C08G 61/02

(54) **Isolationsschichtmaterial für integrierte Schaltkreise in Damascene-Architektur, bestehend aus Molekülen die nur auf der Oberfläche mit Atomen besetzt sind, wie z.B. Fullerenen**
Isolation material for layers in intergrated circuits with damascene archtitecture, comprising molecules having atoms at the surface only, like for example fullerenes
Matériau d'isolation pour couches dans circuits intégrés aux architecture damascene, comprenant des molécules qui portent des atomes seulement au surface, comme par example les fullerenes

(30) Priorität: 14.11.2002 DE 10253855
(43) Veröffentlichungstag der Anmeldung: 19.05.2004
(73) Patentinhaber: Leibniz-Institut für Festkörper- und Werkstoffforschung Dresden e.V., 01069 Dresden (DE)
(72) Erfinder: HERMANN, Helmut, 01187, Dresden (DE); TÄSCHNER, Christine, 01217, Dresden (DE); ZSCHECH, Ehrenfried, 01468, Moritzburg (DE)
(74) Vertreter: Rauschenbach, Marion

(56) Entgegenhaltungen:
- WO-A-02/058139
- US-A- 5 317 058
- US-A- 5 744 399
- US-A1- 2002 016 414
- US-B1- 6 277 766
- US-B1- 6 294 467

## Beschreibung

Die Erfindung bezieht sich auf die Gebiete der Elektrotechnik und Elektronik/Mikroelektronik, der Physik und der Werkstoffwissenschaften und betrifft ein Isolationsschichtmaterial für integrierte Schaltkreise in Damascene-Architektur, wie es beispielsweise als Dielektrikum zwischen Kupferleiterbahnen zur Anwendung kommen kann.

Bekannt ist der Einsatz von homogenem SiO₂ als Dielektrikum in der Mikroelektronik (Miller, R.D., Science 286 (1999) 421-422). Unter anderem kann das SiO₂ durch plasmagestützte chemische Dampfabscheidung (PE-CVD) aufgebracht werden. Derartige Dielektrika erreichen Werte für die Dielektrizitätskonstante von k = 3,9 bis 4,2.
Mit zunehmender Integrationsdichte und steigender Leistung pro Chip kann das Dielektrikum SiO₂ aufgrund des hohen k-Wertes zukünftig nicht mehr eingesetzt werden.

Weiterhin sind als Dielektrika poröse SiO₂-Materialien bekannt (Zhang, J.-Y. u.a., Mater. Sci. in Semiconductor Processing 3 (2000) 345-349; Murray, C. u.a., Microelectronic Engng. 60 (2002)133-141), wobei sich diese Materialien gegenwärtig noch in der Testphase für den Einsatz befinden. Aufgebracht werden können diese Materialien unter anderem durch katalytische Sol-Gel-Polymerisation von Orthosilicat-Estern. Das Solvent wird aus der Gelschicht durch überkritische Extraktion entfernt (Aerogele) oder durch Solventaustausch und Trocknung (Xerogele) beseitigt. Derartige Dielektrika erreichen Werte für die Dielektrizitätskonstante von k = 1,7 bis 3,6.
Die Nachteile dieser Dielektrika sind der sehr hohe Herstellungsaufwand. Die Porositätsgrade liegen mit 50 bis 80 % sehr hoch und die Poren sind ungünstigerweise offen und zum großen Teil miteinander verbunden. Weiterhin ist die Porengrößenverteilung nicht ausreichend gut beherrschbar. Es können Poren und Kanäle miteinander verbundener Poren entstehen, die zur elektrischen Verbindung benachbarter Leitbahnen führen, die von dem Dielektrikum getrennt werden sollten. Dies kann zum Ausfall des Chip führen.

Auch bekannt ist der Einsatz von homogenen Polymeren als Dielektrika. Allerdings erreichen nur die hochfluorierten Alkan-Derivate k-Werte von < 2,2, wie beispielsweise PTFE mit k-Werten von 1,9 bis 2,1 (Wang, J. u.a., Scripta mater. 42 (2000) 687-694). PTFE-Schichten können aus Surfactant-stabilisierten wässrigen Mikroemulsionen hergestellt werden.
Nachteilig beim Einsatz derartiger Isolationsschichten sind deren ungenügenden mechanischen Eigenschaften und Unsicherheiten bezüglich der Stabilität bei Temperaturen oberhalb 400 °C. Desweiteren gibt es Bedenken bezüglich der Wirkung fluorierter Dielektrika auf das Metall der Leiterbahnen bei erhöhten Temperaturen.

Eine weitere Möglichkeit zur Bildung von Dielektrika in der Mikroelektronik ist durch Wasserstoff- und Methyl-Silsesquioxane (HSQ und MSQ) gegeben. Die Wirkung dieser Materialien beruht auf der strukturell käfigartigen Anordnung von Si-, O- und H-Atomen (HSQ) oder auf den amorphen Si-O-Netzwerken (MSQ), die CH₃-Bindungen enthalten und die strukturell bei Temperaturen bis zu 500 °C modifiziert werden (Das, A, u.a. Microelectronic Engng. 64 (2002) 11-24).
Beispielsweise kann das spezielle MSQ-Material LKD-5109 mit dynamischer Dispens in einem TEL ACT 8 spin Track auf ein Si-Substrat aufgebracht werden. Anschließend findet ein Temperschritt über 3 min bei 200 °C statt. Nach Säuberung mit PGMEA folgt eine Wärmebehandlung über 1 h bei 420 °C.
Derartige Materialien erreichen k-Werte von über 2,0 bei einer mittleren Porengröße von 2 nm. Die Poren sind dabei vermutlich nicht miteinander verbunden.

Die Nachteile auch dieser Materialien liegen in der nicht erreichten vollen Integration in den Herstellungsprozess der Mikroelektronik und in den Unsicherheiten, die unter anderem die Abschätzung der Lebensdauer mit den zur Zeit bekannten Methoden betreffen.

Ebenfalls bekannt ist aus der US 2002/0016414A1 ein organisches Isolationsmaterial mit niedriger Dielektrizitätskonstante und einer käfigartigen Struktur. Dieses Isolationsmaterial besteht aus einer ersten und zweiten Polymerrückgratkette, die durch reaktive Gruppen miteinander verbunden sind. Weiterhin sind an die Polymerrückgratketten Käfigstrukturmoleküle mit mindestens 10 Atomen kovalent gebunden.

Aus der US 5,744,399 ist weiterhin ein Verfahren zur Herstellung von Isolationsschichtmaterialien mit niedriger Dielektrizitätskonstante und unter Verwendung von Fullerenen bekannt. Aus Fig. 1A und aus der Beschreibung dazu ist ersichtlich, dass es offensichtlich nicht auf eine spezielle Anordnung der Fullerene im Matrixmaterial ankommt und eine Berührung der Fullere untereinander vorkommen kann.

Die Aufgabe der Erfindung besteht in der Angabe eines Isolationsschichtmaterials für integrierte Schaltkreise in Damascene-Architektur, das k-Werte von < 4,0 bei einer einstellbaren Porengröße von < 2,0 nm aufweist.

Die Aufgabe wird durch die in den Ansprüchen angegebene Erfindung gelöst. Weiterbildungen sind Gegenstand der Unteransprüche.

Erfindungsgemäß enthält das Isolationsschichtmaterial für integrierte Schaltkreise in Damascene-Architektur Moleküle oder besteht aus Molekülen, die nur auf der Oberfläche mit Atomen besetzt sind, und die durch weitere Moleküle oder Molekülgruppen in einem Abstand zueinander von ≤ 2 nm voneinander getrennt angeordnet sind, wobei die weiteren Moleküle oder Molekülgruppen eine Größe von ≤ 2 nm aufweisen und mindestens zwei Stellen besitzen, die mit den Molekülen, die nur an der Oberfläche mit Atomen besetzt sind, über chemische Bindungen verbunden sind.

Es ist vorteilhaft, dass die Moleküle, die in dem Isolationsschichtmaterial enthalten sind oder aus denen das Isolationsschichtmaterial besteht, durch weitere Moleküle oder Molekülgruppen voneinander räumlich getrennt und gleichzeitig durch diese weiteren Moleküle oder Molekülgruppen miteinander verstrebt angeordnet sind.

Vorteilhafterweise besteht das Isolationsschichtmaterial vollständig aus Molekülen, die nur auf der Oberfläche mit Atomen besetzt sind und aus weiteren Molekülen oder Molekülgruppen, die die Moleküle, die nur auf der Oberfläche mit Atomen besetzt sind, voneinander trennen.

Ebenfalls vorteilhafterweise kann das Isolationsschichtmaterial aus an sich bekannten Isolationsschichtmaterialien bestehen, in das Moleküle, die nur auf der Oberfläche mit Atomen besetzt sind, und die durch weitere Moleküle oder Molekülgruppen voneinander getrennt werden, integriert sind.

Weiterhin vorteilhafterweise sind die Moleküle, die nur an de Oberfläche mit Atomen besetzt sind, kugelförmig oder polyederförmig oder annähernd kugelförmig oder polyederförmig.

Ebenfalls vorteilhafterweise sind die kugelförmigen oder polyederförmigen Moleküle Fullerene oder Heterofullerene.

Im Falle des Vorliegens von Fullerenen sind diese vorteilhafterweise vom Typ C₂ₙ mit 2n ≥ 20.

Auch vorteilhafterweise sind die weiteren Moleküle oder Molekülgruppen bekannte Kohlenwasserstoffe mit angelagerten anderen Atomen, wie beispielsweise und vorzugsweise Silicium-, Sauerstoff-, Fluor-Atome, oder siliciumorganische Verbindungen.

Die Moleküle, die nur an der Oberfläche mit Atomen besetzt sind, weisen im Inneren einen Hohlraum, in den meisten Fällen ein Vakuum, auf. Damit bilden sie innerhalb des erfindungsgemäßen Isolationsschichtmaterials eine Pore.

Nach dem gegenwärtigen Stand der Technik (Low-*k*-Dielektrika, Expertenworkshop, Bonn, 13.11.2001, Redaktion: G. Schumacher, B. Steingrobe) ist bekannt, dass die gewünschten Isolationsschichten für integrierte Schaltkreise in Damascene-Architektur nur durch poröse Materialien erreicht werden.
Andererseits ist bekannt, dass die dichteste Packung von Fullerenen nicht zu einer Verbesserung der Dielektrizitätskonstante führt. Daher ist es für die Erfindung besonders vorteilhaft, eine Packung von 20 bis 70 % von Molekülen, die nur an der Oberfläche mit Atomen besetzt sind, innerhalb des Isolationsschichtmaterials zu realisieren.

Mit der erfindungsgemäßen Lösung sind sowohl die Form, die Größe als auch die Anzahl und die Verteilung der Poren in dem Isolationsschichtmaterial in weiten Grenzen variabel und steuerbar.
Je nach Form und Größe der eingesetzten Moleküle werden die Porenformen und - größen bestimmt. Vorteilhaft sind dabei möglichst kugelförmige Poren, die insbesondere durch Fullerene vom Typ C₂ₙ mit 2n ≥ 20 erreicht werden.
Die Anzahl wird über die Menge an eingebrachten Molekülen, die nur auf der Oberfläche mit Atomen besetzt sind, gesteuert.

Hinsichtlich der Verteilung der Poren in der Schicht ist besonders wichtig, dass der mittlere Durchmesser der Poren kleiner ist als ein Zwanzigstel des für die jeweilige Technologie typischen Abstandes. Beträgt der typische Abstand beispielsweise 130 nm (z.B. in der 130 nm-Damascene-Technologie), dann muss der mittlere Porendurchmesser kleiner als 6,5 nm sein. Insbesondere dürfen keine Poren oder Kanäle aus miteinander verbunden Poren auftreten, deren Abmessungen größer als ein Zehntel (Killerporen) des für die jeweilige Technologie typischen Abstandes sind. Die so entstehenden Porenkanäle würden dann zu einem Versagen der Isolationsschicht führen. (Low-*k*-Dielektrika, Expertenworkshop, Bonn, 13.11.2001, Redaktion: G. Schumacher, B. Steingrobe)
Erfindungsgemäß verhindert wird dies, indem die Moleküle, die nur auf der Oberfläche mit Atomen besetzt sind, mit weiteren Molekülen oder Molekülgruppen verbunden sind, die als Abstandshalter wirken. Dabei besitzen die Moleküle und Molekülgruppen, die als Abstandshalter wirken sollen, mindestens zwei Stellen, über die die Moleküle, die nur an der Oberfläche mit Atomen besetzt sind, über chemische und/oder physikalische Wechselwirkungen verbunden sind. Die Verbindung kann dabei chemisch und/oder physikalisch erfolgen und ist erfindungsgemäß möglichst stabil. Derartige Verbindungen können sowohl chemische Bindungen aber auch van der Waals-Kräfte sein. Die als Abstandshalter wirkenden Moleküle oder Molekülgruppen können vorteilhafterweise auch mehr als zwei derartige aktive Stellen aufweisen, wodurch eine stabile räumliche Verbindung zwischen den Molekülen, die nur auf der Oberfläche mit Atomen besetzt sind, erreicht werden kann, die sowohl hinsichtlich der Anzahl der Verbindungen als auch bezüglich der Abstände zwischen den einzelnen Molekülen gezielt einstellbar ist.

Die Bedingung, dass die mittlere Porengröße unter einem Zwanzigstel und die maximale Porengröße unter einem Zehntel des für die jeweilige Technologie typischen Abstandes liegen muss, ist nicht nur von den Molekülen, die nur auf der Oberfläche mit Atomen besetzt sind, einzuhalten. Diese Bedingung muss auch von den Zwischenräumen zwischen den Molekülen eingehalten werden. Das bedeutet, dass die Moleküle oder Molekülgruppen, die als Abstandshalter wirken, kürzer als ein Zwanzigstel des für die jeweilige Technologie typischen Abstandes ein müssen.

Die als Abstandshalter wirkenden Moleküle oder Molekülgruppen trennen dabei die Moleküle, die nur auf der Oberfläche mit Atomen besetzt sind, räumlich voneinander, gleichzeitig können sie aber Verstrebungen zwischen diesen Molekülen, die nur auf der Oberfläche mit Atomen besetzt sind, bilden, so dass diese Moleküle innerhalb der Isolationsschicht auf ihrem Platz gehalten werden.

Als Materialien für die Moleküle und Molekülgruppen, die als Abstandshalter wirken, können vorteilhafterweise Kohlenwasserstoffe mit angelagerten anderen Atomen, wie beispielsweise und noch vorteilhafterweise Silicium-, Sauerstoff-, Fluor-Atome, oder siliciumorganische Verbindungen oder ein Netzwerk auf SiO₂-Basis eingesetzt werden, die eine besonders stabile und weitgehend enge Verbindung zwischen zwei Fullerenen bilden.

**Mit der erfindungsgemäßen Lösung können nahezu ideale Verteilungen der Poren im Isolationsschichtmaterial erreicht werden.**

Durch die Variation der Länge der Moleküle und Molekülgruppen, die als Abstandshalter wirken, und ihre chemische Realisierung können die Eigenschaften des Isolationsschichtmaterials modifiziert und den konkreten Prozessbedingungen angepasst werden. Durch Vergrößerung der Länge der Moleküle und Molekülgruppen, die als Abstandshalter wirken, wird die Dichte und damit die Dielektrizitätskonstante des Materials verringert, was der Sinn der Erfindung ist. Die Länge muss dabei kleiner als ein Zehntel des für die jeweilige Technologie typischen Abstandes sein. Mit der Erhöhung der Stärke der chemischen Bindung zwischen den kugelförmigen oder polyederförmigen Molekülen und den Abstandshalter-Molekülen wird die mechanische Belastbarkeit des Materials erhöht.

Ein besonderer Vorteil der Erfindung ist es, dass die erfindungsgemäßen Moleküle, die nur auf der Oberfläche mit Atomen besetzt sind, gemeinsam mit den Molekülen und Molekülgruppen, die als Abstandshalter wirken, auch in an sich bekannte Isolationsschichtmaterialien integriert werden können. Ein derartiges Isolationsschichtmaterial könnte beispielsweise ein konventionelles SiO₂-Dielektrikum sein, in dessen SiO₂-Netzwerk die Moleküle mit ihren Abstandshaltern eingebunden werden können. Andererseits könnte in einem derartigen SiO₂-Dielektrikum der Abstand zwischen den Molekülen, die nur an der Oberfläche mit Atomen besetzt sind, auch durch das SiO₂-Material realisiert werden.

Eine Möglichkeit zur Realisierung des erfindungsgemäßen Isolationsschichtmaterials besteht in der wechselweisen Aufbringung von beispielsweise Fullerenschichten und SiO₂-Schichten. Durch eine Erwärmung während oder nach der Aufbringung der Schichten wird eine ganz oder teilweise Durchmischung beider Materialien erreicht, die zu den fertigen erfindungsgemäßen Isolationsschichten führt. Dabei dürfen die eingesetzten Materialien durch die Temperaturerhöhung nicht ihre Funktionen verlieren.

Im weiteren wird die Erfindung an mehreren Ausführungsbeispielen näher erläutert.

### Beispiel 1

Auf ein Substrat aus Silicium wird eine 10 nm dicke Schicht aus C₆₀-Molekülen im Vakuum aufgedampft und nachfolgend mit Hilfe eines plasmaaktivierten Verfahrens im Vakuum (< 1000 Pa) behandelt. Als Reaktionspartner ist Sauerstoff vorhanden in Kombination mit Argon und Phenoxytrimethylsilan.
Dabei entsteht eine 35 nm dicke Isolationsschicht, deren Poren aus C₆₀-Molekülen bestehen, die durch Si-OC₂H₅-Gruppen in einem Abstand von 1,5 nm voneinander gehalten werden.
Das Substrat mit einer derartigen Isolationsschicht wird bekanntermaßen zu einem integrierten Schaltkreis mit Leibahnen aus Aluminium weiterverarbeitet.
Die mit dem erfindungsgemäßen Material erreichte Dielektrizitätskonstante beträgt k = 1,7

### Beispiel 2

Auf ein Substrat aus Silicium werden Einzelschichten aus einer 1 nm dicken Schicht aus C₆₀-Molekülen, die im Vakuum aufgedampft worden sind, und aus einer weiteren Einzelschicht realisiert, die mit Hilfe eines plasmaaktivierten Verfahrens im Vakuum (> 1000 Pa) aus Tetraethoxysilan und Sauerstoff und Argon gebildet wird. Diese Einzelschichten werden abwechselnd bis zu einer Gesamtschichtdicke von 20 nm aufgebracht.
Es entsteht eine Isolationsschicht, in der C₆₀-Moleküle als Poren und die C₆₀-Moleküle miteinander verstrebende SiO_{1,5}-Material enthalten sind. Dieses SiO_{1,5}-Material hält die C₆₀-Moleküle in einem Abstand von 2 nm voneinander.
Das Substrat mit einer derartigen Isolationsschicht wird bekanntermaßen zu einem integrierten Schaltkreis in Kupfertechnologie weiterverarbeitet, das heißt, dass die Leitbahnen aus Kupfer hergestellt worden sind.
Die mit dem erfindungsgemäßen Material erreichte Dielektrizitätskonstante beträgt k = 2,9.

### Beispiel 3

Kugelförmige Fullerene C₇₀ werden im Vakuum im Lichtbogen hergestellt und anschließend in Lösung in einer Diels-Alder-Reaktion mit 2-Siloxy-1,3-dienen exohedral funktionalisiert. Das entstandene Cycloaddukt wird in einem Spin-On-Verfahren in gelöster Form auf ein Siliciumsubstrat aufgebracht. Nach Entfernung des Lösungsmittels wird die aufgebrachte Schicht im Vakuum bei 400 °C getempert. Dabei entsteht eine 30 nm dicke Isolationsschicht, deren Poren aus C₇₀-Molekülen bestehen und die durch chemisch gebundene SiO- und CH₂-CH-Gruppen in einem Abstand von < 2 nm voneinander getrennt gehalten werden.
Das Substrat mit einer derartigen Isolationsschicht wird bekanntermaßen zu einem integrierten Schaltkreis in Kupfertechnologie weiterverarbeitet, das heißt, dass die Leitbahnen aus Kupfer hergestellt worden sind.
Die mit dem erfindungsgemäßen Material erreichte Dielektrizitätskonstante beträgt k = 3,5.

## Patentansprüche

1. Isolationsschichtmaterial für integrierte Schaltkreise in Damascene-Architektur, enthaltend oder bestehend aus Molekülen, die nur auf der Oberfläche mit Atomen besetzt sind so dass sie im Inneren einen Hohlraum aufweisen, und die durch weitere Moleküle oder Molekülgruppen in einem Abstand zueinander von ≤ 2 nm voneinander getrennt angeordnet sind, wobei die weiteren Moleküle oder Molekülgruppen eine Größe von ≤ 2 nm aufweisen und mindestens zwei Stellen besitzen, die mit den Molekülen, die nur an der Oberfläche mit Atomen besetzt sind, über chemische Bindungen verbunden sind.

2. Isolationsschichtmaterial nach Anspruch 1, bei dem die Moleküle, die im Isolationsschichtmaterial enthalten sind oder aus denen das Isolationsschichtmaterial besteht, durch weitere Moleküle oder Molekülgruppen voneinander räumlich getrennt und gleichzeitig durch diese weiteren Moleküle oder Molekülgruppen miteinander verstrebt angeordnet sind.

3. Isolationsschichtmaterial nach Anspruch 1, bei dem das Isolationsschichtmaterial vollständig aus Molekülen, die nur auf der Oberfläche mit Atomen besetzt sind und aus weiteren Molekülen oder Molekülgruppen, die die Moleküle, die nur auf der Oberfläche mit Atomen besetzt sind, voneinander trennen, besteht.

4. Isolationsschichtmaterial nach Anspruch 1, bei dem das Isolationsschichtmaterial aus Isolationsschichtmaterialien besteht, in das Moleküle, die nur auf der Oberfläche mit Atomen besetzt sind, und die durch weitere Moleküle oder Molekülgruppen voneinander getrennt werden, integriert sind.

5. Isolationsschichtmaterial nach Anspruch 1, bei dem die Moleküle, die nur auf der Oberfläche mit Atomen besetzt sind, kugelförmig oder polyederförmig oder annähernd kugelförmig oder polyederförmig sind.

6. Isolationsschichtmaterial nach Anspruch 5, bei dem die Moleküle Fullerene oder Heterofullerene sind.

7. Isolationsschichtmaterial nach Anspruch 6, bei dem die Fullerene vom Typ C₂ₙ mit 2n ≥ 20 sind.

8. Isolationsschichtmaterial nach Anspruch 1, bei dem die weiteren Moleküle oder Molekülgruppen Kohlenwasserstoffe mit angelagerten anderen Atomen, wie beispielsweise und vorzugsweise Silicium-, Sauerstoff-, Fluor-Atome, und siliciumorganische Verbindungen sind.

## Claims

1. Insulation layer material for integrated circuits in damascene architecture, comprising or consisting of molecules which comprise atoms only at the surface, such that they have a cavity in the interior, and which are arranged separated from one another at a distance of ≤ 2 nm by further molecules or molecule groups, said further molecules or molecule groups having a size of ≤ 2 nm and possessing at least two sites which are joined via chemical bonds to the molecules comprising atoms only at the surface.

2. Insulation layer material according to Claim 1, in which the molecules present in the insulation layer material or of which the insulation layer material consists are spatially separated from one another by further molecules or molecule groups and, at the same time, are arranged braced to one another by these further molecules or molecule groups.

3. Insulation layer material according to Claim 1, in which the insulation layer material consists entirely of molecules which comprise atoms only on the surface and of further molecules or molecule groups which separate the molecules comprising atoms only on the surface from one another.

4. Insulation layer material according to Claim 1, in which the insulation layer material consists of insulation layer materials, into which molecules which comprise atoms only on the surface and which are separated from one another by further molecules or molecule groups are integrated.

5. Insulation layer material according to Claim 1, in which the molecules which comprise atoms only on the surface are spherical or polyhedral or virtually spherical or polyhedral.

6. Insulation layer material according to Claim 5, in which the molecules are fullerenes or heterofullerenes.

7. Insulation layer material according to Claim 6, in which the fullerenes are of the C₂ₙ type where 2n ≥ 20.

8. Insulation layer material according to Claim 1, in which the further molecules or molecule groups are hydrocarbons with other atoms attached, for example and with preference silicon, oxygen and fluorine atoms, and organosilicon compounds.

## Revendications

1. Matériau pour couches isolantes destinées à des circuits intégrés à structure damascène, ledit matériau contenant ou étant constitué de molécules ne comportant d'atomes que sur leur surface et possédant ainsi une cavité à l'intérieur, lesdites molécules étant espacées de ≤ 2 nm les unes des autres par d'autres molécules ou groupements de molécules dont la dimension est ≤ 2 nm et qui sont pourvus d'au moins deux sites de liaison chimique les reliant auxdites molécules ne comportant d'atomes que sur leur surface.

2. Matériau pour couches isolantes selon la revendication 1, lesdites molécules contenues dans le matériau pour couches isolantes ou constituant le matériau pour couches isolantes étant espacées les unes des autres par d'autres molécules ou groupements de molécules, ces autres molécules ou groupements de molécules servant en même temps à les entretoiser.

3. Matériau pour couches isolantes selon la revendication 1, ledit matériau pour couches isolantes étant entièrement constitué de molécules ne comportant d'atomes que sur leur surface et d'autres molécules ou groupements de molécules espaçant les molécules ne comportant d'atomes que sur leur surface les unes des autres.

4. Matériau pour couches isolantes selon la revendication 1, ledit matériau pour couches isolantes étant constitué de matériaux pour couches isolantes dans lesquels sont intégrées des molécules ne comportant d'atomes que sur leur surface qui sont séparées les unes des autres par d'autres molécules ou groupements de molécules.

5. Matériau pour couches isolantes selon la revendication 1, lesdites molécules ne comportant d'atomes que sur leur surface étant d'une forme sphérique, polyédrique ou d'une forme s'approchant d'une sphère ou d'un polyèdre.

6. Matériau pour couches isolantes selon la revendication 5, lesdites molécules étant des fullerènes ou des hétérofullerènes.

7. Matériau pour couches isolantes selon la revendication 6, lesdits fullerènes étant de type C₂ₙ, avec 2n ≥ 20.

8. Matériau pour couches isolantes selon la revendication 1, lesdits autres molécules ou groupements de molécules étant des hydrocarbures auxquels sont liés d'autres atomes comme, par exemple et de préférence, des atomes de silicium, d'oxygène ou de fluor ou bien des composés organosiliciques.
